# EUROPEAN PATENT APPLICATION

(11) **EP 4 842 166 A1**
(43) Date of publication of application: **18.11.2026**
(21) Application number: 26176585.3
(22) Date of filing: 05.05.2026
(51) Int. Cl.: H10F 39/00

(54) **PHOTOELECTRIC CONVERSION DEVICE AND EQUIPMENT**

(30) Priority: 15.05.2025 JP 2025082125
(71) Applicant: Canon Kabushiki Kaisha, Tokyo 146-8501 (JP)
(72) Inventor: INOUE, Kazuma, Tokyo, 146-8501 (JP); MORIMOTO, Kazuhiro, Tokyo, 146-8501 (JP); SEKINE, Hiroshi, Tokyo, 146-8501 (JP)
(74) Representative: Canon Europe Limited

(57) **Abstract**

A photoelectric conversion device (100) in which pixels (101) each including an avalanche photodiode (201) are arranged in a semiconductor layer (300) having first and second surfaces (351, 352) is provided. The avalanche photodiode (201) includes an avalanche multiplication portion (402) including a first semiconductor region (301) of a first conductivity type and a second semiconductor region (302) of a second conductivity type between the first semiconductor region (301) and the second surface (352). The pixels (101) are separated by a first portion (314) and a second portion (305) between the first portion (314) and the first surface (351). The first portion (314) includes an induction film (304). The second portion (305) does not include the induction film (304) and contacts a semiconductor region (312) of the first conductivity type or a semiconductor region (312) of the second conductivity type and having a lower concentration than the second semiconductor region (302). A length from a boundary of the first and second portions (314, 305) to the second surface (352) is shorter than a length from the first semiconductor region (301) to the second surface (352).

## Description

### TECHNICAL FIELD

The present disclosure relates to a photoelectric conversion device and equipment.

### BACKGROUND

There is known a photoelectric conversion element using an avalanche photodiode (APD) that causes avalanche multiplication capable of detecting faint light of a single photon level. Japanese Patent Laid-Open No. 2022-071828 describes that, in a photoelectric conversion element using an APD, a pinning film is arranged in a portion of the trench structure of a separation portion, which separates photoelectric conversion elements from each other, contacting a semiconductor region. By arranging the pinning film, even if an unnecessary charge is generated due to the formation of the trench structure, it becomes difficult to be read out as a signal.

### SUMMARY

When the pixel size becomes finer, an electric field is concentrated between the cathode of the APD and the pinning film, and the dark count rate (DCR) may increase.

Some embodiments of the present disclosure provide a technique advantageous in improving the characteristics of a photoelectric conversion device.

The present disclosure in its first aspect provides a photoelectric conversion device as specified in claim 1. Optional features are specified in claims 2 to 14.

The present disclosure in its second aspect provides equipment as specified in claim 15.

Features of the present disclosure will become apparent from the following description of embodiments with reference to the attached drawings. The following description of embodiments is described by way of example.

### BRIEF DESCRIPTION OF THE DRAWINGS

Fig. 1 is a view showing an arrangement example of a photoelectric conversion device according to an embodiment;
Fig. 2 is a view showing an arrangement example of the pixel array of the photoelectric conversion device shown in Fig. 1;
Fig. 3 is a block diagram showing an arrangement example of the photoelectric conversion device shown in Fig. 1;
Fig. 4 is a circuit diagram showing an arrangement example of the pixel of the photoelectric conversion device shown in Fig. 1;
Figs. 5A and 5B are views for explaining an operation example of the pixel of the photoelectric conversion device shown in Fig. 1;
Fig. 6 is a plan view showing an arrangement example of the pixels of the photoelectric conversion device shown in Fig. 1;
Figs. 7A and 7B are sectional views showing the arrangement example of the pixels shown in Fig. 6;
Figs. 8A to 8D are sectional views showing an example of steps for manufacturing the pixels shown in Fig. 6;
Figs. 9A to 9C are sectional views showing an example of steps for manufacturing the pixels shown in Fig. 6;
Figs. 10A and 10B are sectional views showing an arrangement example of the pixels shown in Fig. 6;
Figs. 11A and 11B are sectional views showing an arrangement example of the pixels shown in Fig. 6;
Fig. 12 is a plan view showing an arrangement example of the pixels of the photoelectric conversion device shown in Fig. 1;
Figs. 13A and 13B are sectional views showing the arrangement example of the pixels shown in Fig. 12;
Fig. 14 is a plan view showing an arrangement example of the pixels of the photoelectric conversion device shown in Fig. 1;
Figs. 15A and 15B are sectional views showing the arrangement example of the pixels shown in Fig. 14; and
Fig. 16 is a view showing an arrangement example of equipment incorporating the photoelectric conversion device shown in Fig. 1.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

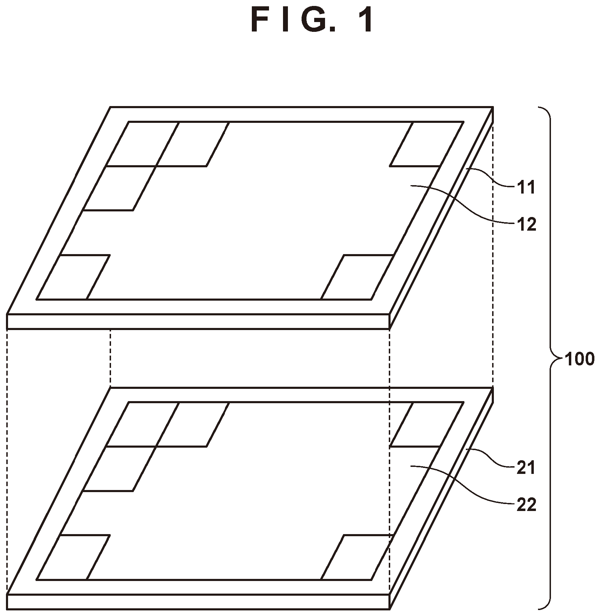

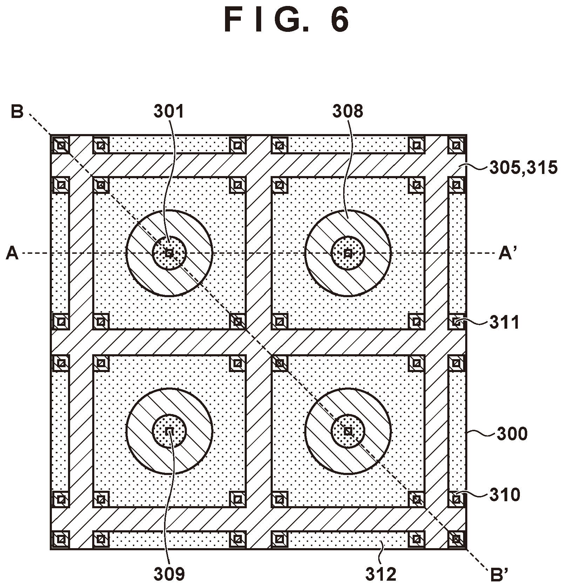

First, with reference to Figs. 1 to 5B, an avalanche photodiode (to be sometimes referred to as an APD hereinafter) that is used in a photoelectric conversion device 100 to be described below will be described. Fig. 1 is a view showing an arrangement example of the photoelectric conversion device 100. The photoelectric conversion device 100 can be constituted by stacking two boards, that is, a sensor board 11 and a circuit board 21 and electrically connecting them. That is, the photoelectric conversion device 100 may be a stacked device. As will be described later, a semiconductor layer 300 (to be described with reference to Fig. 6 and subsequent drawings) where a plurality of pixels 101 are arranged, and the like are arranged in the sensor board 11. A pixel region 12 including the plurality of pixels 101 is arranged in the sensor board 11. A circuit region 22 for processing signals detected in the pixel region 12 is arranged in the circuit board 21.

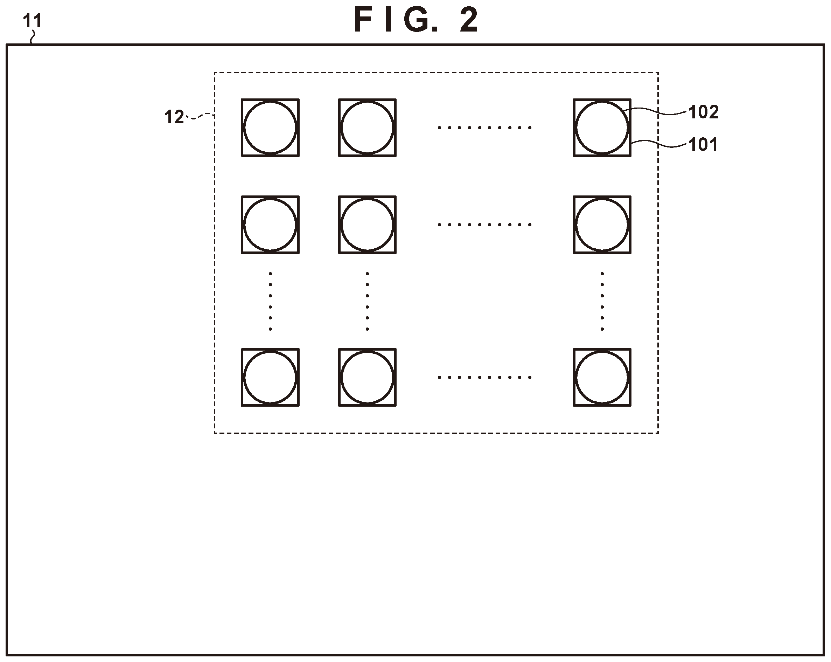

Fig. 2 is a view showing an arrangement example of the sensor board 11. The pixels 101 each including a photoelectric conversion element 102, that includes an APD as a photodiode, are arranged in a two-dimensional array in an orthogonal projection to the main surface of the sensor board 11, forming the pixel region 12. The pixel 101 is typically a pixel for generating an image, but when it is used in a Time of Flight (ToF) distance measurement device or the like, does not necessarily generate an image. That is, the pixel 101 may be configured to measure the time when light arrives and the quantity of light.

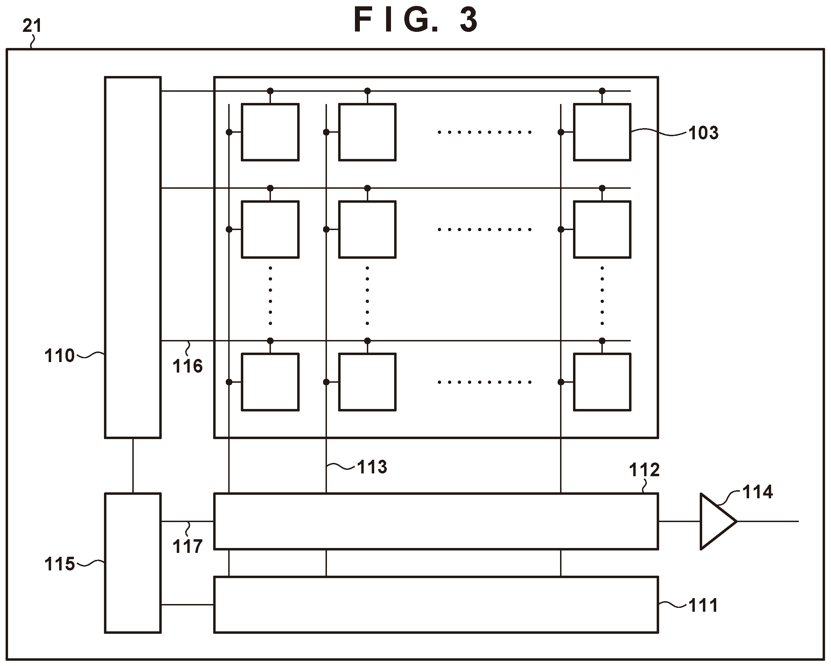

Fig. 3 is a block diagram showing an arrangement example of the circuit board 21. The circuit board 21 includes signal processing circuits 103 that process charges photoelectrically converted by the photoelectric conversion elements 102 shown in Fig. 2, a readout circuit 112, a control pulse generation circuit 115, a horizontal scanning circuit 111, signal lines 113, a vertical scanning circuit 110, and the like. The signal processing circuits 103 shown in Fig. 3 may be arranged so as to correspond to each pixel 101 shown in Fig. 2. In this case, the pixel 101 (photoelectric conversion element 102) and the signal processing circuit 103 may be electrically connected via a connection wiring provided for each pixel 101.

The vertical scanning circuit 110 receives a control pulse supplied from the control pulse generation circuit 115, and supplies a control pulse to the respective pixels 101 via driving lines 116. A logic circuit such as a shift register or an address decoder can be used for the vertical scanning circuit 110.

A signal output from the pixel 101 is processed by the signal processing circuit 103. A counter, a memory, and the like can be provided in the signal processing circuit 103. The memory can hold, as a digital value, a count value obtained by counting by the counter.

The horizontal scanning circuit 111 inputs, to the signal processing circuits 103, a control pulse for sequentially selecting respective columns in order to read out signals from the memories of the signal processing circuits 103 corresponding to the respective pixels 101 in which digital signals are held. As for a selected column, a signal is output to the signal line 113 from the signal processing circuit 103 corresponding to the pixel 101 selected by the vertical scanning circuit 110. The signal output to the signal line 113 is output via an output circuit 114 to a recording unit or a signal processing unit outside the photoelectric conversion device 100.

The array of the pixels 101 in the pixel region 12 shown in Fig. 2 is not limited to a two-dimensional array. The pixels 101 may be arranged one-dimensionally (in a line). The function of the signal processing circuit 103 need not always be provided one by one in all the pixels 101 (photoelectric conversion elements 102). For example, one signal processing circuit 103 may be shared by two or more pixels 101 (photoelectric conversion elements 102) to sequentially perform signal processing.

As shown in Figs. 2 and 3, the signal processing circuits 103 can be arranged in a region overlapping the pixel region 12 in an orthogonal projection to the pixel region 12. The vertical scanning circuit 110, the horizontal scanning circuit 111, the readout circuit 112, the output circuit 114, the control pulse generation circuit 115, and the like can be so arranged as to overlap a gap between the end of the sensor board 11 and the end of the pixel region 12. In other words, the sensor board 11 has the pixel region 12 and a non-pixel region (peripheral region) arranged around the pixel region 12. In this case, the vertical scanning circuit 110, the horizontal scanning circuit 111, the readout circuit 112, the output circuit 114, and the control pulse generation circuit 115 can be arranged in a region overlapping the non-pixel region.

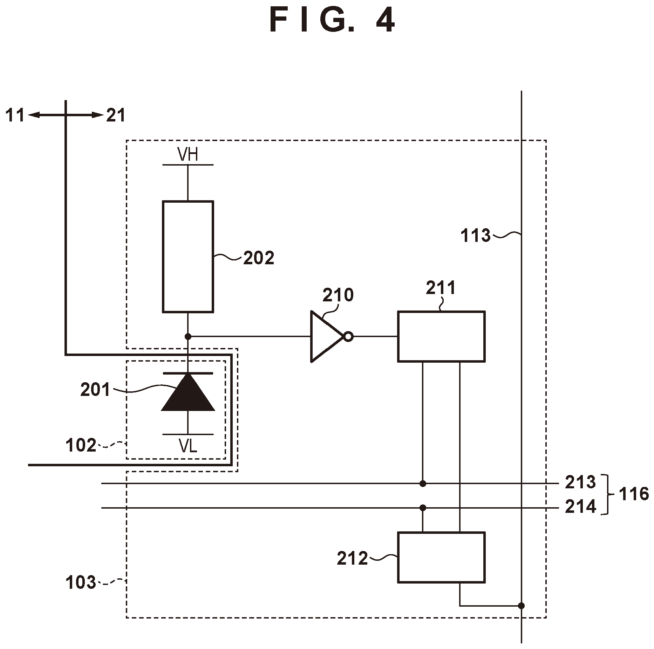

Fig. 4 shows an example of a block diagram including an equivalent circuit focusing on one pixel 101 (photoelectric conversion element 102). In Fig. 4, the photoelectric conversion element 102 including the APD 201 is provided in the sensor board 11, and the remaining components are provided in the circuit board 21.

The APD 201 generates a charge pair corresponding to incident light by photoelectric conversion. A potential VL is supplied to the anode of the APD 201. A potential VH, which is higher than the potential VL supplied to the anode, is supplied to the cathode of the APD 201. A reverse bias voltage is supplied to the anode and the cathode so that the APD 201 performs an avalanche multiplication operation. In a state in which such a reverse bias voltage is supplied, charges generated by incident light cause avalanche multiplication, generating an avalanche current.

In a case where the reverse bias voltage is supplied to the APD 201, there are a Geiger mode in which the APD 201 is operated by a potential difference (voltage) between the anode and the cathode larger than a breakdown voltage, and a linear mode in which the APD 201 is operated by a potential difference between the anode and the cathode equal to or smaller than the breakdown voltage. An APD operated in the Geiger mode is called a Single Photon Avalanche Diode (SPAD). For example, the potential VL is -30 V, and the potential VH is 1 V. The APD 201 may be operated in the linear mode or the Geiger mode.

The quench element 202 is connected between the APD 201 and a power supply that supplies the potential VH. The quench element 202 functions as a load circuit (quench circuit) at the time of signal multiplication by avalanche multiplication, and operates to suppress a voltage supplied to the APD 201 and suppress avalanche multiplication (quench operation). The quench element 202 also operates to return the voltage supplied to the APD 201 to a voltage (VH - VL) by supplying a current by an amount corresponding to a voltage drop caused by the quench operation (recharge operation).

The signal processing circuit 103 can include a waveform shaping circuit 210, a counter circuit 211, and a selection circuit 212. In this specification, the signal processing circuit 103 suffices to include any of the waveform shaping circuit 210, the counter circuit 211, and the selection circuit 212.

The waveform shaping circuit 210 shapes a potential change of the cathode of the APD 201 that is obtained at the time of photon detection, and outputs a pulse signal. As the waveform shaping circuit 210, for example, an inverter circuit is used. In the arrangement shown in Fig. 4, the use of one inverter as the waveform shaping circuit 210 is exemplified. However, the present disclosure is not limited to this, and a circuit constituted by series-connecting a plurality of inverters may be used as the waveform shaping circuit 210, or another circuit having the waveform shaping effect may be used.

The counter circuit 211 counts pulse signals output from the waveform shaping circuit 210 and holds the count value. When a control pulse pRES is supplied from the vertical scanning circuit 110 shown in Fig. 3 via a driving line 213 corresponding to a part of the driving line 116 shown in Fig. 3, the signal held by the counter circuit 211 is reset.

The selection circuit 212 receives a control pulse pSEL from the vertical scanning circuit 110 via a driving line 214 corresponding to a part of the driving line 116 shown in Fig. 3, and switches electrical connection or disconnection between the counter circuit 211 and the signal line 113. The selection circuit 212 can include, for example, a buffer circuit for outputting a signal.

A switching element such as a transistor may be interposed between the quench element 202 and the APD 201 or between the photoelectric conversion element 102 and the signal processing circuit 103 so that electrical connection can be switched. Similarly, supply of the potential VH or potential VL to the photoelectric conversion element 102 may be electrically switchable using a switching element such as a transistor.

In this embodiment, the counter circuit 211 is arranged in the signal processing circuit 103. However, the present disclosure is not limited to this, and a Time-to-Digital Converter (TDC) and a memory may be used instead of the counter circuit 211 so that the photoelectric conversion device 100 obtains a pulse detection timing. In this case, the generation timing of a pulse signal output from the waveform shaping circuit 210 is converted into a digital signal by the TDC. The TDC receives a control pulse pREF (reference signal) from the vertical scanning circuit 110 via the driving line 116 for measurement of the timing of the pulse signal. By using the control pulse pREF as a reference, the TDC obtains, as a digital signal, a signal when the input timing of a signal output from each pixel 101 via the waveform shaping circuit 210 is regarded as a relative time.

In the arrangement shown in Fig. 4, the quench element 202, the waveform shaping circuit 210, the counter circuit 211, and the selection circuit 212 are arranged in one circuit board 21. However, the present disclosure is not limited to this. For example, the quench element 202 and the waveform shaping circuit 210 may be arranged in one board, the counter circuit 211 and the selection circuit 212 may be arranged in another board, and these boards may be stacked.

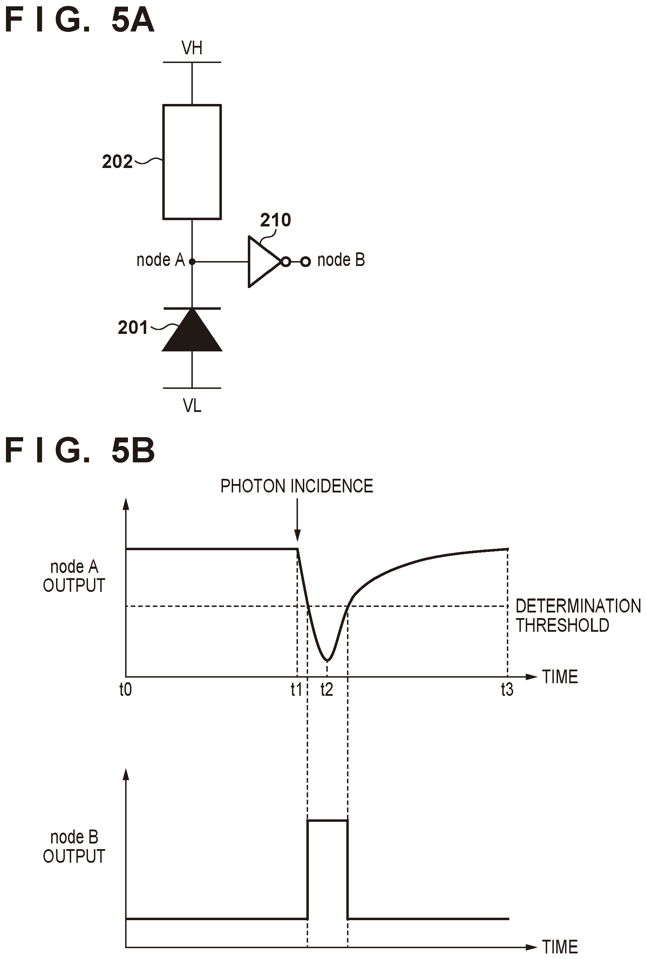

Figs. 5A and 5B are views schematically showing the relationship between the operation of the APD 201 and an output signal. Fig. 5A is a view showing an excerpt of the APD 201, quench element 202, and waveform shaping circuit 210 shown in Fig. 4. Here, the input side of the waveform shaping circuit 210 is a node A and its output side is a node B. Fig. 5B shows waveform changes at the node A and the node B.

From time t0 to time t1, a potential difference (voltage) of the potential VH - the potential VL is applied to the APD 201. When a photon enters the APD 201 at time t1, avalanche multiplication occurs in the APD 201, an avalanche multiplication current flows into the quench element 202, and the potential of the node A drops. When the voltage drop amount further increases and the potential difference applied to the APD 201 decreases, the avalanche multiplication of the APD 201 stops as shown at time t2, and the potential level of the node A does not drop any more from a predetermined value. In a period between time t2 and time t3, a current compensating for the voltage drop from the potential VL flows to the node A. At time t3, the node A is settled at the original potential level. A portion at which the output waveform exceeds a given threshold at the node A is waveform-shaped by the waveform shaping circuit 210 and output as a signal to the node B.

The arrangement of the signal lines 113, readout circuit 112, and output circuit 114 is not limited to the arrangement shown in Fig. 3. For example, each signal line 113 may be arranged to extend in the row direction (the longitudinal direction in Fig. 3), and the readout circuit 112 may be arranged at the end of the signal line 113.

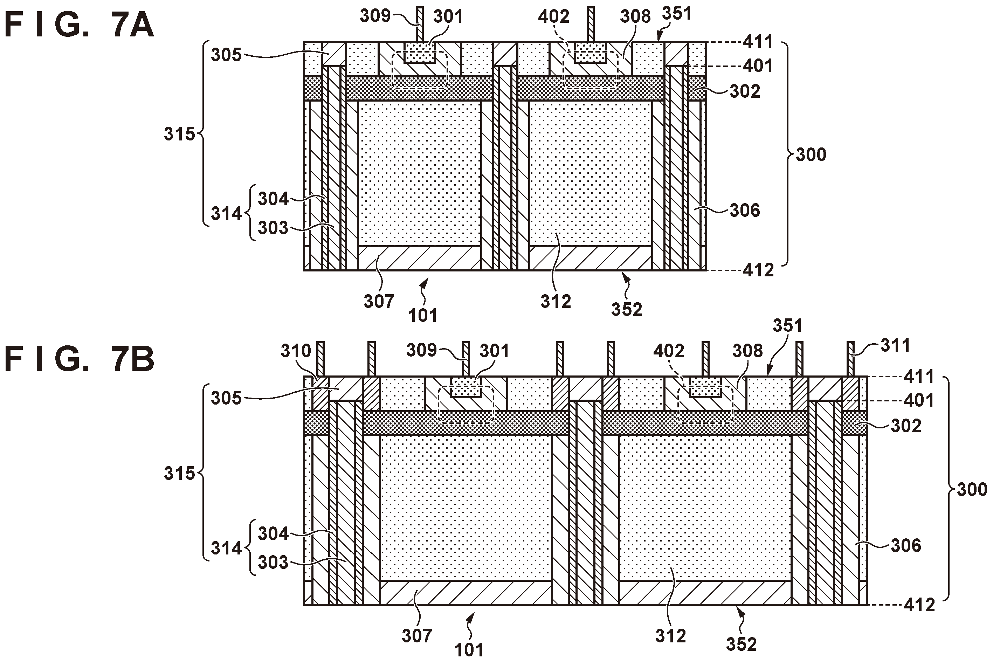

Next, the arrangement of the pixels 101 arranged in the photoelectric conversion device 100 according to this embodiment will be described in detail. Fig. 6 is a plan view showing the arrangement of the pixels 101 arranged in the pixel region 12. Fig. 7A is a sectional view taken along a line A - A' shown in Fig. 6, and Fig. 7B is a sectional view taken along a line B - B' shown in Fig. 6. Fig. 6 is a plan view at a surface 351 of the semiconductor layer 300 shown in Figs. 7A and 7B. The semiconductor layer 300 shown in Figs. 6 to 7B is a semiconductor layer where the pixels 101 (photoelectric conversion elements 102) arranged in the sensor board 11 are formed. In this embodiment, the pixel 101 can have a so-called back-illuminated type sensor configuration. In Figs. 7A and 7B, light enters from the lower side of each drawing. The circuit board 21 is arranged on the upper side of each drawing.

As the above-described photoelectric conversion element 102, each of the plurality of pixels 101 includes the APD 201 formed in the semiconductor layer 300 provided in the sensor board 11. It can also be said that the plurality of pixels 101 each including the APD 201 as the photoelectric conversion element 102 are arranged in the semiconductor layer 300 having the surface 351 and a surface 352. Each pixel 101 (APD 201) is separated by a separation portion 315 extending between the surface 351 and the surface 352 of the semiconductor layer 300 and arranged to electrically separate the APDs 201 adjacent to each other. Although not shown in Figs. 7A and 7B, the photoelectric conversion device 100 further includes the circuit board 21 that includes a semiconductor layer, which is different from the semiconductor layer 300 and arranged to face the surface 351 of the semiconductor layer 300 (sensor board 11), as shown in Fig. 1, via an insulating layer or the like including a wiring pattern (wiring layer) or the like. Elements such as transistors for operating the APDs 201 serving as the photoelectric conversion elements 102 can be arranged in the semiconductor layer of the circuit board 21.

Each pixel 101 includes a semiconductor region 301 and semiconductor region 308 of the same conductivity type as the signal carrier. The pixel 101 further includes a semiconductor region 302, a semiconductor region 306, a semiconductor region 307, and a semiconductor region 310 of a conductivity type opposite to the conductivity type of the semiconductor regions 301 and 308. For example, the semiconductor regions 301 and 308 may be n-type semiconductor regions, and the semiconductor regions 302, 306, 307, and 310 may be p-type semiconductor regions. In that case, a semiconductor region 312 may be an n-type semiconductor region, or a p-type semiconductor region having a lower impurity concentration than the semiconductor region 302. An example of the semiconductor material used for the semiconductor layer 300 is silicon. Accordingly, each of the semiconductor regions 301, 302, 306, 307, 308, 310, and 312 can be a region obtained by doping an impurity corresponding to the conductivity type to silicon. For example, each of the semiconductor regions 301, 302, 306, 307, 308, and 310 may be formed in the n-type semiconductor layer 300 (semiconductor region 312) using an ion implantation method or the like.

In the arrangement shown in Figs. 7A and 7B, light enters from the lower side of each drawing. That is, in the semiconductor layer 300, the surface 352 is the light incident surface. Color filters, microlenses, or the like can be arranged on the surface 352 (on the lower side in the drawing) of the semiconductor layer 300. In the arrangement shown in Figs. 6 to 7B, the n-type semiconductor region 301 is arranged in the vicinity of the surface 351 of the semiconductor layer 300, and the n-type semiconductor region 308 is arranged around the semiconductor region 301. The p-type semiconductor region 302 is arranged at a position overlapping the semiconductor region 301 and the semiconductor region 308 in an orthogonal projection to the surface 351 of the semiconductor layer 300. Hereinafter, the expression "the semiconductor regions overlap" indicates that the semiconductor regions overlap in an orthogonal projection to the surface 351 of the semiconductor layer 300. The expression "overlap" may also be used in other arrangements.

The semiconductor region 301 is a region having a higher n-type impurity concentration than the semiconductor region 308. For example, the impurity concentration of the semiconductor region 301 may be about 10¹⁸ cm⁻³ to 10²⁰ cm⁻³, and the impurity concentration of the semiconductor region 308 may be about 10¹⁵ cm⁻³ to 10¹⁸ cm⁻³. When the semiconductor region 312 is the n-type region, the impurity concentration of the semiconductor region 312 may be 10¹⁷ cm⁻³ or less, for example, 10¹⁵ cm⁻³ or less.

A p-n junction portion is formed between the n-type semiconductor region 301 arranged between the surface 351 and the surface 352 of the semiconductor layer 300 and the p-type semiconductor region 302 arranged between the semiconductor region 301 and the surface 352 of the semiconductor layer 300. By setting the impurity concentration of the semiconductor region 302 lower than the impurity concentration of the semiconductor region 301, a reverse bias is applied and the whole region of the semiconductor region 302 overlapping the center of the semiconductor region 301 becomes a depletion region. Further, the depletion region extends to a partial region of the semiconductor region 301, and a strong electric field is induced in the depletion region. This strong electric field forms an avalanche multiplication portion 402 where avalanche multiplication is induced in the depletion region extending to the partial region of the semiconductor region 301, and a current based on the multiplied charges is output as a signal charge. When the light having entered the pixel 101 is photoelectrically converted and avalanche multiplication is induced in the depletion region (avalanche multiplication portion 402), the generated n-type charges (carriers) are collected in the semiconductor region 301.

The semiconductor region 301 is connected to the node A shown in Fig. 5A via a contact plug 309 and the like. The semiconductor region 302 is connected to the supply line for supplying the potential VL shown in Figs. 4 and 5A via the semiconductor region 310, a contact plug 311, and the like. By setting the impurity concentration of the semiconductor region 310 higher than the impurity concentration of the semiconductor region 302, the contact resistance between the semiconductor region 310 and the contact plug 311 is reduced.

In this embodiment, as shown in Figs. 7A and 7B, the p-type semiconductor region 306 contacting the semiconductor region 302 is arranged in the outer edge portion of each of the plurality of pixels 101 between the semiconductor region 302 and the surface 352 of the semiconductor layer 300. With this, charges can be collected from a wide range to the semiconductor region 301. The outer edge of the pixel 101 can be defined by the separation portion 315. The semiconductor region 308 may be not the n-type semiconductor region but a p-type semiconductor region. In this case, the impurity concentration of the semiconductor region 308 is set lower than the impurity concentration of the semiconductor region 302. If the impurity concentration of the semiconductor region 308 is too high, an avalanche multiplication region is generated between the semiconductor region 308 and the semiconductor region 301, and the Dark Count Rate (DCR) may increase.

As described above, each pixel 101 is separated by the separation portion 315. The separation portion 315 includes a portion 314, and a portion 305 arranged between the portion 314 and a virtual plane 411 including the surface 351 of the semiconductor layer 300. By arranging the separation portion 315, crosstalk between the pixels 101 adjacent to each other can be reduced. As shown in Figs. 7A and 7B, the portion 314 of the separation portion 315 may constitute a part of a virtual plane 412 including the surface 352 of the semiconductor layer 300, and the portion 305 of the separation portion 315 may constitute a part of the virtual plane 411 including the surface 351 of the semiconductor layer 300.

The portion 314 of the separation portion 315 includes an induction film 304 that induces p-type carriers at the interface with the semiconductor layer 300. The portion 314 also includes a base portion 303 formed of an insulator or a conductor such as a metal inside the induction film 304. The induction film 304 is a film having negative fixed charges and serving to reduce the DCR. A material such as aluminum oxide, tantalum oxide, hafnium oxide, zirconium oxide, or titanium oxide can be used for the induction film 304. By providing the induction film 304, a region where positive charges accumulate is formed in the semiconductor layer 300 in the vicinity of the induction film 304, which substantially behaves as a p-type semiconductor region. Since this substantially p-type region absorbs electrons (dark current), the DCR can be reduced. The base portion 303 may be embedded with an insulator or a conductor, or may have a void. The base portion 303 may include, for example, a conductor layer and an insulator layer arranged between a metal layer and the induction film 304. However, the present disclosure is not limited to this, and a proper configuration for separating the pixels 101 from each other may be used as the base portion 303. The base portion 303 may be formed of one material, or may be formed using a plurality of materials. As the insulator, silicon oxide, silicon nitride, silicon oxynitride, or the like may be used. As the conductor, a metal such as tungsten, titanium, aluminum, gold, silver, copper, or platinum may be used. When the base portion 303 uses a metal, even if avalanche light emission occurs when avalanche multiplication is induced, crosstalk between the pixels 101 adjacent to each other can be suppressed. As the conductor, for example, a transparent conductive material such as indium tin oxide or indium zinc oxide may be used.

The portion 305 of the separation portion 315 is formed to include an insulator. The portion 305 may be embedded with an insulator, or may have a void. The portion 305 may be formed of one material, or may be formed using a plurality of materials. As the insulator, silicon oxide, silicon nitride, silicon oxynitride, or the like may be used. The portion 305 of the separation portion 315 does not include the induction film 304 at the interface with the semiconductor layer 300. Therefore, for example, the insulator constituting the portion 305 of the separation portion 315 contacts the semiconductor layer 300.

When the base portion 303 of the portion 314 uses an insulator, and the insulator included in the base portion 303 and the insulator included in the portion 305 include the same insulating material, the base portion 303 and the portion 305 may be formed consecutively. In that case, a boundary 401 between the portion 314 and the portion 305 may be observed to be consecutive between the base portion 303 of the portion 314 and the portion 305. However, the position of the boundary 401 between the portion 314 and the portion 305 of the separation portion 315 can be decided based on whether the induction film 304 is arranged at the interface with the semiconductor layer 300.

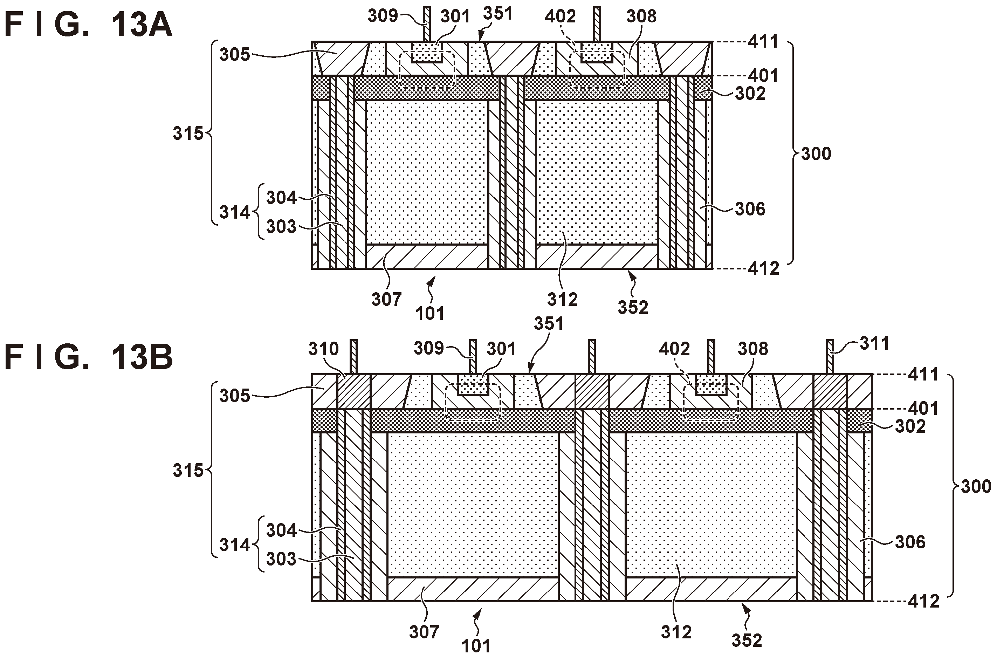

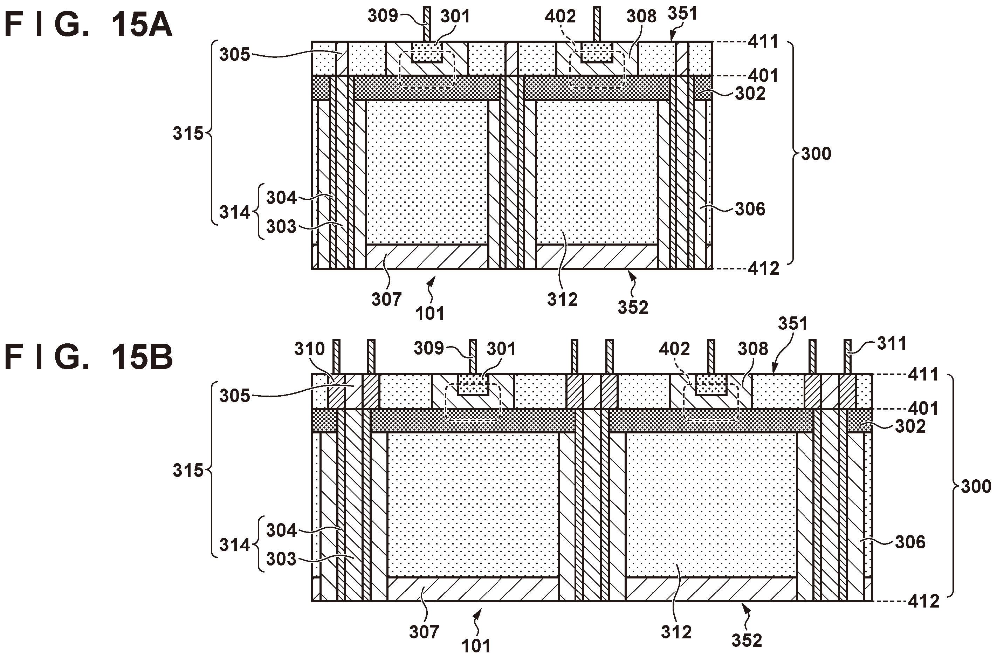

Next, the position where the boundary 401 between the portion 314 and the portion 305 of the separation portion 315 is arranged will be described. In this embodiment, as shown in Figs. 7A and 7B, the length from the boundary 401 between the portion 314 and the portion 305 of the separation portion 315 to the virtual plane 412 including the surface 352 of the semiconductor layer 300 is shorter than the length from the semiconductor region 301 to the virtual plane 412. When the surface 351 of the semiconductor layer 300 is used as a reference, it can be said that the boundary 401 between the portion 314 and the portion 305 of the separation portion 315 is arranged at a deeper position than the semiconductor region 301. In addition, as shown in Figs. 7A and 7B, the length from the boundary 401 between the portion 314 and the portion 305 of the separation portion 315 to the virtual plane 411 including the surface 351 of the semiconductor layer 300 may be shorter than the length from the semiconductor region 302 to the virtual plane 411. When the surface 351 of the semiconductor layer 300 is used as a reference, it can be said that the boundary 401 between the portion 314 and the portion 305 of the separation portion 315 is arranged at a shallower position than the semiconductor region 302. However, the present disclosure is not limited to this. As will be shown in Figs. 13A and 13B and Figs. 15A and 15B to be described later, the boundary 401 and the surface of the semiconductor region 302 on the side of the surface 351 of the semiconductor layer 300 may be arranged at the same depth.

In this embodiment, the portion 314 including the induction film 304 at the interface with the semiconductor layer 300 and the portion 305 not including the induction film 304 at the interface with the semiconductor layer 300 are arranged as the separation portion 315. By arranging the induction film 304 in the portion 314, negative charges (dark current), which are caused by dangling bonds generated in the semiconductor layer 300 due to formation of a trench in the separation portion 315, are absorbed and suppressed to be read out as a signal (DCR). The induction film 304 is not arranged in the portion 305. If the induction film 304 is arranged up to the portion 305, the vicinity of the portion 305 behaves substantially as the p-type semiconductor region, and the potential VL supplied to the semiconductor region 302 may also be supplied to the vicinity of the portion 305. Hence, the electric field may be concentrated between the vicinity of the portion 305 and the semiconductor region 301 supplied with the potential VH, and the DCR may increase. On the other hand, in this embodiment, the portion 305 contacts the semiconductor region 312 without being arranged with the induction film 304. Hence, the potential VL is difficult to be supplied to the vicinity of the portion 305 between the portion 305 and the semiconductor region 301, so that concentration of the electric field can be suppressed. Therefore, increase of the DCR can be suppressed.

As shown in Figs. 7A and 7B, the boundary 401 between the portion 314 and the portion 305 of the separation portion 315 is arranged at the depth between a region where the semiconductor region 301 is arranged and a region where the semiconductor region 302 is arranged. This can suppress the influence of dark current caused by dangling bonds generated due to formation of a trench in the separation portion 315, and also suppress concentration of the electric field in the region near the surface 351 of the semiconductor layer 300. In addition, by providing, in the outer edge portion of the pixel 101, the p-type semiconductor region 306 contacting the semiconductor region 302 and extending from the semiconductor region 302 to the surface 352 of the semiconductor layer 300, the influence of dark current can further be suppressed. As a result, the photoelectric conversion device 100 with the suppressed DCR can be implemented.

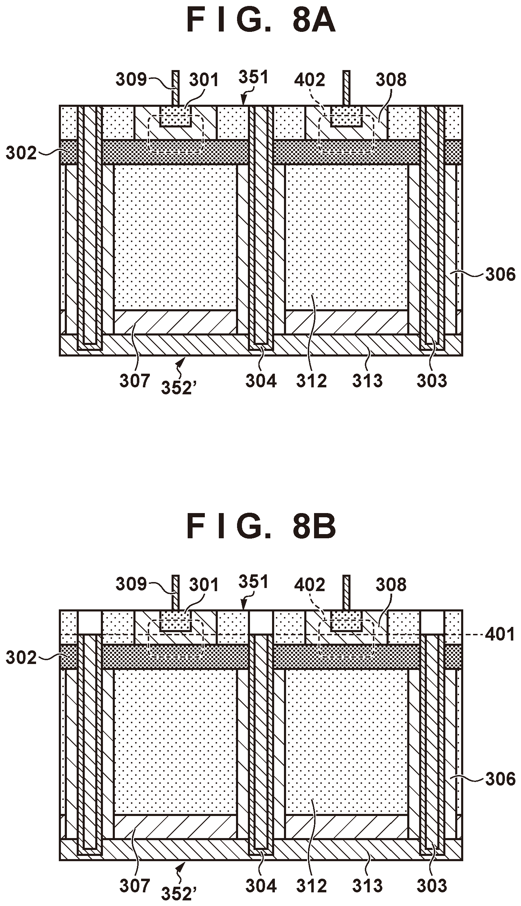

Figs. 8A to 8D are views showing an example of the method of forming the separation portion 315 in the steps for manufacturing the photoelectric conversion device 100. First, the semiconductor layer 300 where the semiconductor regions 301, 302, 306, 307, 308, 310, and 312 are formed is prepared. Then, a trench is formed from the surface 351 of the semiconductor layer 300 using a dry etching method or the like, and the induction film 304 and the base portion 303 are formed in the trench as shown in Fig. 8A. Each of the induction film 304 and the conductor such as a metal or the insulator constituting the base portion 303 can be formed using a proper deposition method such as a sputtering method, a chemical vapor deposition (CVD) method, or an atomic layer deposition (ALD) method. At this time, as shown in Fig. 8A, the trench formed from the surface 351 of the semiconductor layer 300 may not extend through the semiconductor layer 300. Hence, the semiconductor layer 300 can be thicker than in the state shown in Figs. 7A and 7B, and the surface on the opposite side of the surface 351 may be not the surface 352 shown in Figs. 7A and 7B but a surface 352'.

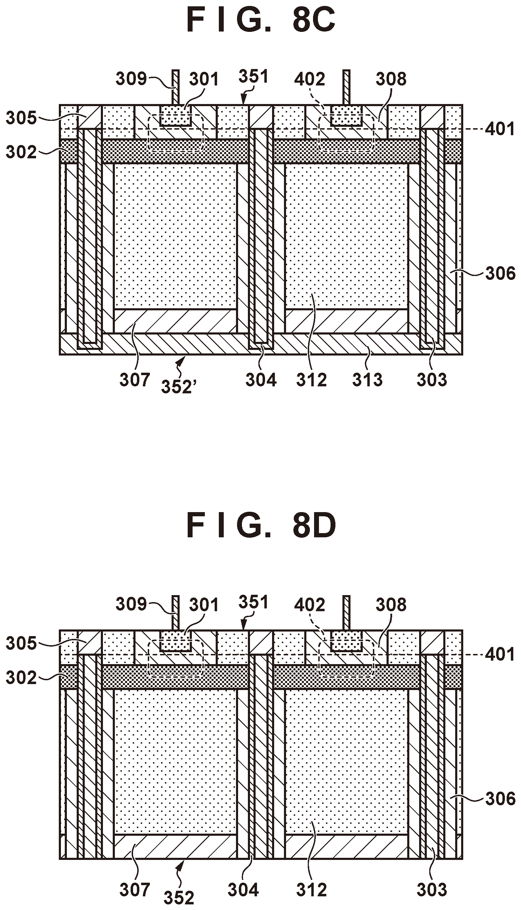

Then, as shown in Fig. 8B, a trench is formed by partially etching the formed induction film 304 and base portion 303 from the surface 351 of the semiconductor layer 300. This trench can be formed using, for example, a dry etching method, a wet etching method, or the like. In this trench, as shown in Fig. 8C, an insulator constituting the portion 305 is formed using the deposition method as described above. Furthermore, as shown in Fig. 8D, the semiconductor layer 300 is thinned from the surface 352' of the semiconductor layer 300 so that the induction film 304 and base portion 303 constituting the portion 314 of the separation portion 315 are exposed. For this step, a proper method such as a dry etching method, a wet etching method, or a chemical mechanical polishing (CMP) method can be used. By using these steps, the separation portion 315 as shown in Figs. 7A and 7B can be formed.

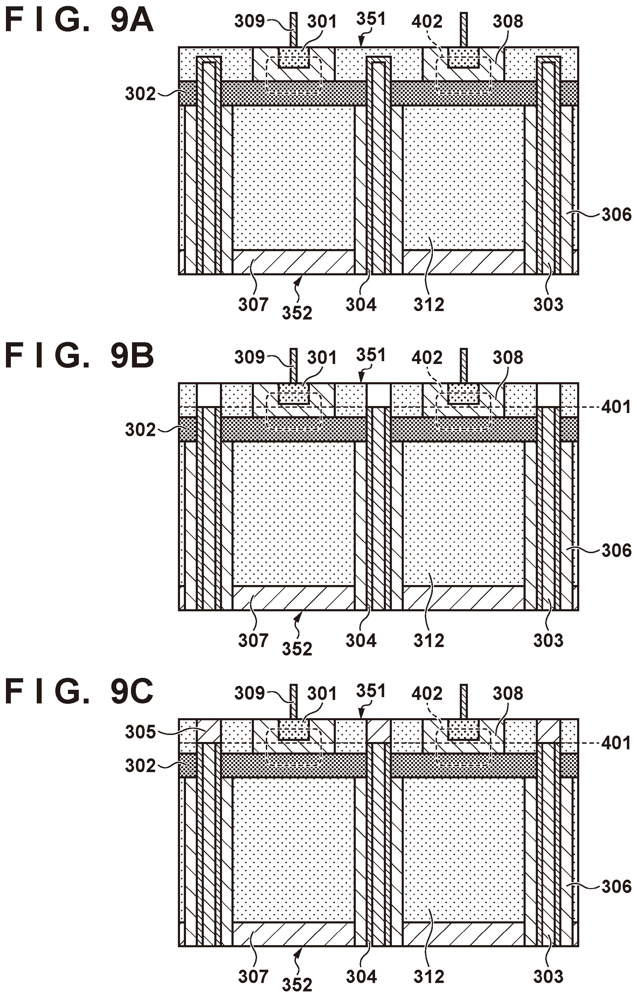

In the steps shown in Figs. 8A to 8D, when forming the separation portion 315, the trench is formed from the side of the surface 351 of the semiconductor layer 300. However, the present disclosure is not limited to this, and the trench may be formed from both the surfaces 351 and 352 of the semiconductor layer 300. Figs. 9A to 9C show an example of the method of forming the separation portion 315 in this case.

First, the semiconductor layer 300 where the semiconductor regions 301, 302, 306, 307, 308, 310, and 312 are formed is prepared. Then, a trench is formed from the surface 352 of the semiconductor layer 300 using a dry etching method or the like, and the induction film 304 and the base portion 303 are formed in the trench as shown in Fig. 9A by using the above-described deposition method or the like. The trench formed at this time can be formed up to a region closer to the surface 351 of the semiconductor layer 300 than a region where the portion 305 of the separation portion 315 is to be formed. Then, as shown in Fig. 9B, a trench for arranging the portion 305 of the separation portion 315 is formed from the surface 351 of the semiconductor layer 300 by using a dry etching method or the like. By forming an insulator in the trench formed from the surface 351, the portion 305 of the separation portion 315 is formed as shown in Fig. 9C. By using these steps, the separation portion 315 as shown in Figs. 7A and 7B can be formed. Here, it has been described that the induction film 304 and base portion 303 constituting the portion 314 of the separation portion 315 are formed first, and the portion 305 of the separation portion 315 is then formed. However, the present disclosure is not limited to this. The portion 305 of the separation portion 315 may be formed first, and the induction film 304 and base portion 303 of the separation portion 315 may be then formed.

In the steps shown in Figs. 9A to 9C, the separation portion 315 is divided into the portion 314 arranged in the trench formed from the surface 352 of the semiconductor layer 300 and the portion 305 arranged in the trench formed from the surface 351 of the semiconductor layer 300. Therefore, depending on the step, the shape change of the portion 314 in the direction from the virtual plane 412 to the virtual plane 411 and the shape change of the portion 305 in the direction from the virtual plane 412 to the virtual plane 411 may be different from each other. More specifically, since the trench to arrange the portion 314 is formed from the surface 352 of the semiconductor layer 300, it can have a tapered shape whose width in the direction along the virtual plane 411 gradually decreases in the direction from the virtual plane 412 to the virtual plane 411. On the other hand, since the trench to arrange the portion 305 is formed from the surface 351 of the semiconductor layer 300, it can have a tapered shape whose width in the direction along the virtual plane 411 gradually increases in the direction from the virtual plane 412 to the virtual plane 411. In this manner, due to the formation method of the separation portion 315, the shape of the portion 314 and the shape of the portion 305 of the separation portion 315 may be different from each other.

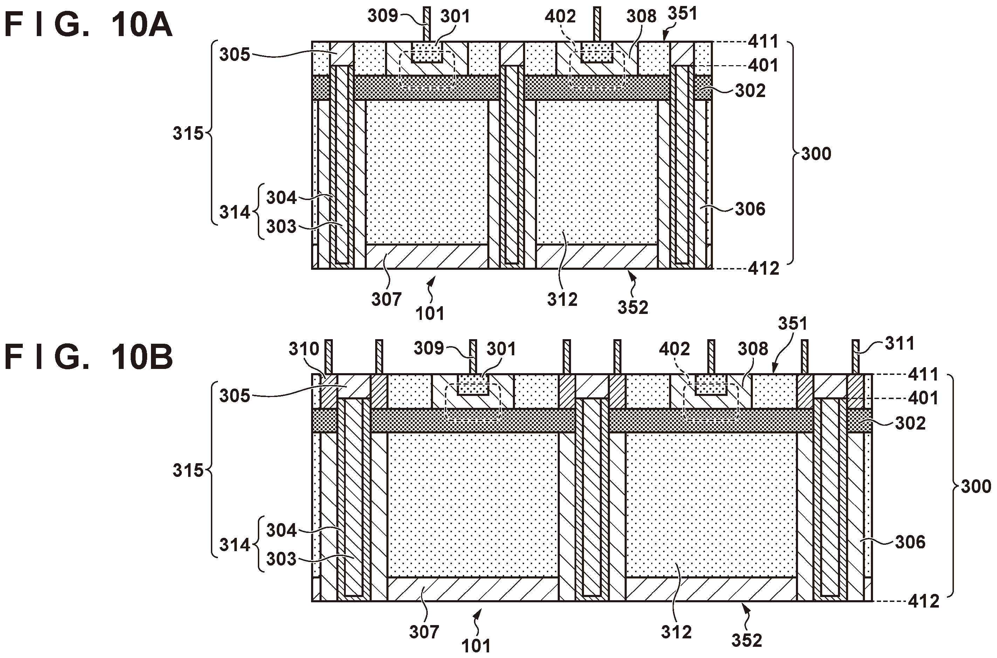

Figs. 10A and 10B are views showing a modification of the arrangement of the separation portion 315 shown in Figs. 7A and 7B. In the arrangement shown in Figs. 10A and 10B, the portion 314 of the separation portion 315 includes the induction film 304 in the surface on the side of the virtual plane 412. In this case, as shown in Figs. 10A and 10B, the induction film 304 may constitute a part of the virtual plane 412. The separation portion 315 shown in Figs. 10A and 10B is formed by, for example, finishing etching or polishing when the induction film 304 is exposed in the thinning step shown in Fig. 8D. Even with the separation portion 315 shown in Figs. 10A and 10B, an effect similar to that of the arrangement shown in Figs. 7A and 7B described above can be obtained.

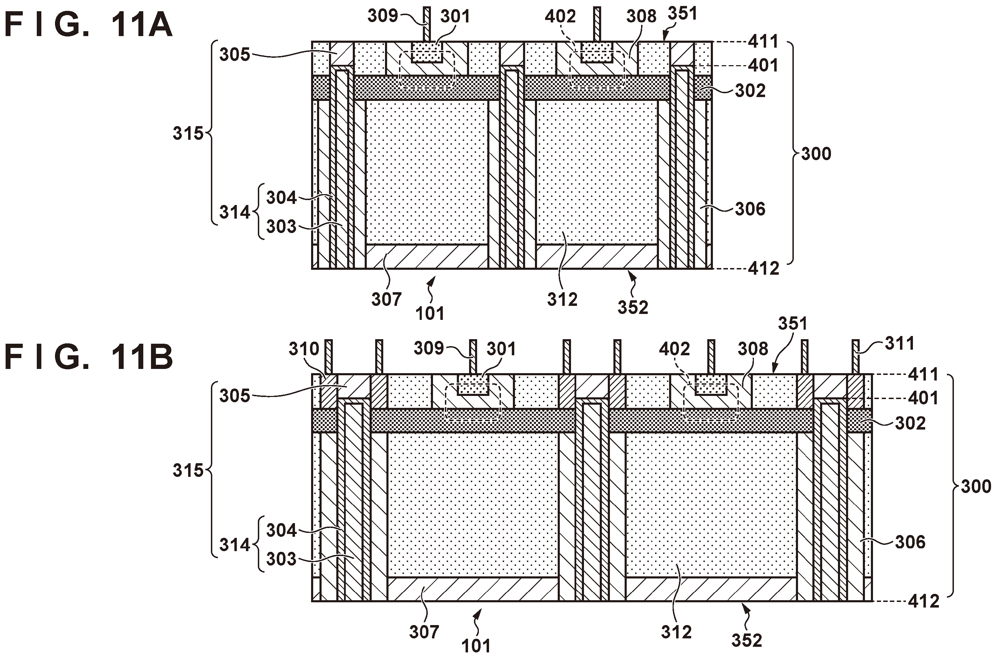

Figs. 11A and 11B are views showing a modification of the arrangement of the separation portion 315 shown in Figs. 7A and 7B. In the arrangement shown in Figs. 11A and 11B, the portion 314 of the separation portion 315 includes the induction film 304 in the surface on the side of the boundary 401 with the portion 305. For example, in the steps shown in Figs. 9A to 9C, the portion 305 of the separation portion 315 is formed first. Then, the portion 314 of the separation portion 315 is formed. Thus, the separation portion 315 shown in Figs. 11A and 11B is formed. Even with the separation portion 315 shown in Figs. 11A and 11B, an effect similar to that of the arrangement shown in Figs. 7A and 7B described above can be obtained.

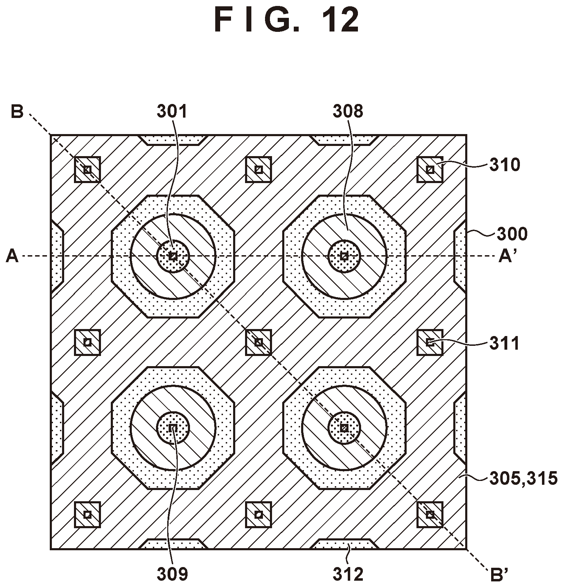

Figs. 12 to 13B are views showing a modification of the arrangement of the separation portion 315 shown in Figs. 7A and 7B. In the arrangement shown in Figs. 12 to 13B, the width of the portion 305 of the separation portion 315 in the direction along the virtual plane 411 is larger than the width of the portion 314 in the direction along the virtual plane 411. In addition, as shown in Fig. 13B, the p-type semiconductor region 310 is arranged at the position between the surface 351 of the semiconductor layer 300 and the portion 314 of the separation portion 315 and overlapping the portion 314 in an orthogonal projection to the surface 351. At this time, the p-type semiconductor region 302 and semiconductor region 310 contact the induction film 304. With this, the potential VL is supplied to the semiconductor region 302 from the contact plug 311 via the semiconductor region 310 and the induction film 304.

By forming the large portion 305 of the separation portion 315, the volume of the semiconductor region (for example, the semiconductor region 312) arranged closer to the surface 351 of the semiconductor layer 300 than the semiconductor region 302 is reduced. A signal carrier photoelectrically converted at a position closer to the surface 351 of the semiconductor layer 300 than the semiconductor region 302 may not undergo avalanche multiplication until it reaches the semiconductor region 301. By reducing the volume of the semiconductor region 312, the sensitivity can be improved. In addition, as shown in Fig. 13B, the side surface of the semiconductor region 310 for supplying the potential VL to the semiconductor region 302 is surrounded by the portion 305 of the separation portion 315 using the insulator. With this, the electric field between the semiconductor region 301 supplied with the potential VH and the semiconductor region 310 supplied with the potential VL can be mitigated. Therefore, the characteristics of the photoelectric conversion device 100 can improve.

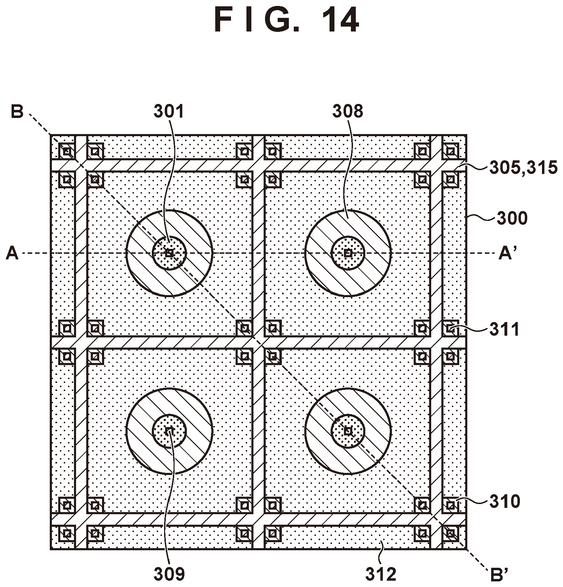

Figs. 14 to 15B are views showing a modification of the arrangement of the separation portion 315 shown in Figs. 7A and 7B. In the arrangement shown in Figs. 14 to 15B, the width of the portion 314 of the separation portion 315 in the direction along the virtual plane 411 is larger than the width of the portion 305 in the direction along the virtual plane 411. With this, it is possible to increase the distance between the portion 305 and the semiconductor region 301 while keeping the width of the portion 314 of the separation portion 315 in the direction along the virtual plane 411. That is, by keeping the width of the portion 314, even if avalanche light emission occurs as described above, crosstalk between the pixels 101 adjacent to each other can be suppressed. On the other hand, since the portion 305 is far from the semiconductor region 301, it is possible to suppress the possibility that negative charges (charges of the same polarity as the signal carrier) caused by dangling bonds generated due to formation of the trench in the separation portion 315 undergoes avalanche multiplication. Therefore, the characteristics of the photoelectric conversion device 100 can improve.

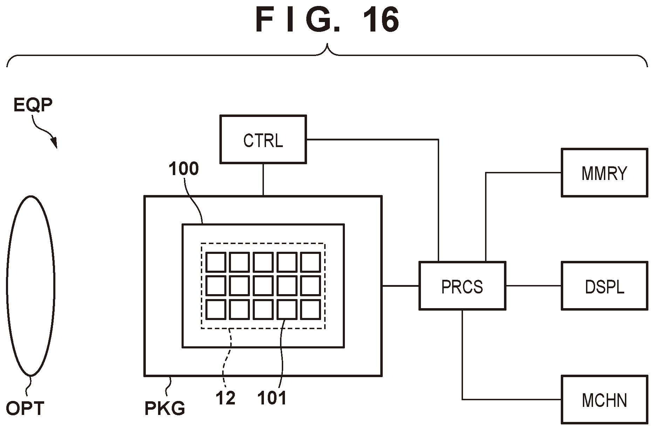

An application example of the photoelectric conversion device 100 according to the above-described embodiment will be described below. Fig. 16 is a schematic view of equipment EQP including the photoelectric conversion device 100. As shown in Fig. 16, the photoelectric conversion device 100 is stored in a semiconductor package PKG. The package PKG can include a base to which the photoelectric conversion device 100 is fixed, a lid member of glass or the like facing the photoelectric conversion device 100, and a conductive connecting member such as bonding wire or bump, which connects a terminal provided on the base and a terminal provided in the photoelectric conversion device 100. The equipment EQP may further include at least one of a control device CTRL, a processing device PRCS, a display device DSPL, and a memory device MMRY.

An optical system OPT forms an image on the pixel region 12 where the plurality of pixels 101 are arranged, and can be, for example, a lens, a shutter, a mirror, or the like. The control device CTRL controls the operation of the photoelectric conversion device 100 and can be, for example, a semiconductor device such as an ASIC. The processing device PRCS processes a signal output from the photoelectric conversion device 100 and can be a semiconductor device such as a CPU or an ASIC. The display device DSPL can be an EL display device or a liquid crystal display device that displays data obtained by the photoelectric conversion device 100. The memory device MMRY can be a magnetic device or a semiconductor device that stores data obtained by the photoelectric conversion device 100. The memory device MMRY can be a volatile memory such as an SRAM or a DRAM, or may be a nonvolatile memory such as a flash memory or a hard disk drive. A machine device MCHN can include a movable portion or a propulsion unit such as a motor or an engine. The machine device MCHN, for example, drives a component of the optical system OPT for a zooming, focusing, or shutter operation. In the equipment EQP, data output from the photoelectric conversion device 100 is displayed on the display device DSPL or transmitted to the outside by a communication device (not shown) provided in the equipment EQP. For this purpose, the equipment EQP may include the memory device MMRY or the processing device PRCS.

The equipment EQP incorporating the photoelectric conversion device 100 can also be applied to a surveillance camera, or an in-vehicle camera mounted in transport equipment such as an automobile, a railway vehicle, a ship, an aircraft, or an industrial robot. In addition, the equipment EQP incorporating the photoelectric conversion device 100 can be applied not only to transport equipment but also widely to equipment that uses object recognition such as an intelligent transport system (ITS).

According to the present disclosure, a technique advantageous in improving the characteristics of a photoelectric conversion device can be provided.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion device (100) in which a plurality of pixels (101) each including an avalanche photodiode (201) are arranged in a semiconductor layer (300) having a first surface (351) and a second surface (352) on an opposite side of the first surface (351), **characterized in that**:
the avalanche photodiode (201) includes an avalanche multiplication portion (402) formed by a first semiconductor region (301) of a first conductivity type having the same polarity as a signal carrier, which is arranged between the first surface (351) and the second surface (352), and a second semiconductor region (302) of a second conductivity type different from the first conductivity type arranged between the first semiconductor region (301) and the second surface (352),
the plurality of pixels (101) are separated by a separation portion (315) including a first portion (314) and a second portion (305) arranged between the first portion (314) and a first virtual plane (411) including the first surface (351),
the first portion (314) includes an induction film (304) configured to induce a carrier of the second conductivity type at an interface with the semiconductor layer (300),
the second portion (305) includes an insulator, does not include the induction film (304) at an interface with the semiconductor layer (300), and contacts a semiconductor region (312) of the first conductivity type or a semiconductor region (312) of the second conductivity type and having a lower impurity concentration than the second semiconductor region (302), and
a length from a boundary between the first portion (314) and the second portion (305) to a second virtual plane (412) including the second surface (352) is shorter than a length from the first semiconductor region (301) to the second virtual plane (412).

2. A photoelectric conversion device (100) according to claim 1, wherein
the avalanche multiplication portion (402) is supplied with a potential via a third semiconductor region (310) contacting a contact plug (311).

3. The photoelectric conversion device (100) according to claim 1 or 2, **characterized in that** a length from the boundary to the first virtual plane (411) is shorter than a length from the second semiconductor region (302) to the first virtual plane (411).

4. The photoelectric conversion device (100) according to any one of claims 1 to 3, **characterized in that** a fourth semiconductor region of the second conductivity type contacting the second semiconductor region (302) is arranged in an outer edge portion of each of the plurality of pixels between the second semiconductor region (302) and the second surface (352).

5. The photoelectric conversion device (100) according to any one of claims 1 to 4, **characterized in that** a shape change of the first portion (314) in a direction from the second virtual plane (412) to the first virtual plane (411) and a shape change of the second portion (305) in the direction from the second virtual plane (412) to the first virtual plane (411) are different from each other.

6. The photoelectric conversion device (100) according to any one of claims 1 to 5, **characterized in that** a width of the first portion (314) in a direction along the first virtual plane (411) is larger than a width of the second portion (305) in the direction along the first virtual plane (411).

7. The photoelectric conversion device (100) according to any one of claims 1 to 5, **characterized in that** a width of the second portion (305) in a direction along the first virtual plane (411) is larger than a width of the first portion (314) in the direction along the first virtual plane (411).

8. The photoelectric conversion device (100) according to any one of claims 1 to 7, **characterized in that** the first portion (314) constitutes a part of the second virtual plane (412).

9. The photoelectric conversion device (100) according to any one of claims 1 to 8, **characterized in that** the first portion (314) includes the induction film (304) in a surface on a side of the second virtual plane (412).

10. The photoelectric conversion device (100) according to any one of claims 1 to 9, **characterized in that** the first portion (305) includes the induction film (304) in a surface on a side of the boundary.

11. The photoelectric conversion device (100) according to any one of claims 1 to 10, **characterized in that** the second portion (305) constitutes a part of the first virtual plane (411).

12. The photoelectric conversion device (100) according to any one of claims 1 to 11, **characterized in that**:
the first portion (314) includes an insulator (303), and
the insulator included in the first portion (314) and the insulator included in the second portion (305) include the same insulating material.

13. The photoelectric conversion device (100) according to any one of claims 1 to 12, **characterized in that**:
a fifth semiconductor region of the second conductivity type is arranged at a position overlapping the first portion (314) in an orthogonal projection to the first surface (351) between the first surface (351) and the first portion (314), and
the second semiconductor region and the fifth semiconductor region contact the induction film (314).

14. The photoelectric conversion device (100) according to claim 13, **characterized in that** a side surface of the fifth semiconductor region is surrounded by the second portion (305).

15. Equipment **characterized by** comprising:
the photoelectric conversion device (100) according to any one of claims 1 to 14;
and
a processing device (PRCS) configured to process a signal output from the photoelectric conversion device (100).
